# FASCICULE DE BREVET EUROPEEN

(11) **EP 0 562 108 B1**
(45) Date de publication et mention de la délivrance du brevet: **27.12.1996**
(21) Numéro de dépôt: 92923834.3
(22) Date de dépôt: 14.10.1992
(51) Int. Cl.: C23C 14/00, C23C 14/06, C23C 14/16, C23C 14/18, C23C 14/20, C23C 28/02, C23C 30/00

(54) **MATERIAU MULTICOUCHE POUR REVETEMENT ANTI-EROSION ET ANTI-ABRASION**
Erosionsbeständiges und abrasionsbeständiges Mehrschichtenmaterial
MULTI-LAYER MATERIAL FOR ANTI-EROSION AND ANTI-ABRASION COATING

(30) Priorité: 14.10.1991 FR 9112616; 09.07.1992 FR 9208500
(43) Date de publication de la demande: 29.09.1993
(73) Titulaire: COMMISSARIAT A L'ENERGIE ATOMIQUE, 75015 Paris (FR); TURBOMECA, Société dite:, F-64511 Bordes (FR); ETAT-FRANCAIS représenté par le DELEGUE GENERAL POUR L'ARMEMENT (DPAG), F-00460 Paris Armées (FR)
(72) Inventeur: PAIDASSI, Serge, F-38000 Grenoble (FR); ERNOULT, Jacques, F-38960 Saint-Etienne-de-Crossey (FR); BRUN, Michel, F-64320 Bizanos (FR); MONGE-CADET, Pierre, F-64160 Serres-Morlaas (FR); PAULEAU, Yves, F-38100 Grenoble (FR); FARGES, Guy, F-91620 La-Ville-du-Bois (FR)
(74) Mandataire: Signore, Robert
(86) Numéro de dépôt international: FR9200969
(87) Numéro de publication internationale: WO9308316

(56) Documents cités:
- EP-A- 0 106 638
- EP-A- 0 186 266
- WO-A-84/04110
- PATENT ABSTRACTS OF JAPAN, vol. 10, no. 90 (C-337)(2147), 08 avril 1986
- PATENT ABSTRACTS OF JAPAN, vol. 2, no. 56 (E)(1489), 24 avril 1978
- JOURNAL OF VACUUM SCIENCE & TECHNOLOGY, A, vol. 6, no. 3, 01 mai 1988, New York, NY (US); H.Y. YANG et al., pp. 1646-1649
- DATABASE WPI Week 5077, Derwent Publications Ltd., London, GB; AN 77-88940Y (50)
- DATABASE WPIL Week 3484, Derwent Publications Ltd., London, GB; AN 84211127 34

## Description

La présente invention concerne un matériau multicouche destiné notamment à permettre la réalisation d'un revêtement anti-érosion et anti-abrasion, ainsi que le procédé de fabrication de ce matériau multicouche.

L'érosion des matériaux constituant des pièces mécaniques soumises à l'impact de particules abrasives telles que le sable ou des poussières est un problème industriel bien connu, par exemple dans le domaine de l'aéronautique. Ainsi, dans le cas des aubes de compresseurs utilisés dans les moteurs d'avions à turbines à gaz, l'usure par érosion des bords d'attaque des aubes, entraîne une dégradation des performances du moteur. De même, les aubes de turbine utilisées dans les centrales électriques sont soumises à des agressions extérieures de particules solides et dures telles que le sable ou l'alumine par exemple. Ces problèmes se retrouvent également dans d'autres secteurs techniques.

Le taux d'érosion des matériaux se définit par le volume ou la masse de matière érodée pour une masse de particules incidentes donnée. Ce taux d'érosion varie avec l'angle d'incidence des particules solides qui frappent la surface du matériau concerné.

Les mécanismes d'érosion ont été étudiés par différents auteurs et notamment par J.P. Massoud, ("Comportement à l'érosion par des particules solides d'un alliage de titane TA6V traité par laser", Thèse de Doctorat en Génie des Matériaux, INSA de Lyon, (1988)). Ces études ont permis de distinguer essentiellement deux types de comportement des matériaux soumis à l'érosion :
- un comportement caractéristique des matériaux ductiles tels que les métaux, qui se détériorent par l'apparition de rayures et d'enlèvement de copeaux. Leur taux d'érosion est faible avec un jet de particules solides à incidence normale (par rapport au plan du matériau), mais est par contre très important à des faibles angles d'impact, c'est-à-dire de l'ordre de 20 à 30° ;
- un comportement caractéristique des matériaux fragiles tels que le verre, les céramiques et les matériaux durs (carbures), pour lesquels le transfert d'énergie par impact se traduit par l'apparition de fissures générant des enlèvements de matière sous forme d'éclats. Le taux d'érosion de ces matériaux est faible avec un jet de particules à faible angle d'incidence (20 à 30°) et élevé avec des angles d'incidence de l'ordre de 50 à 90°.

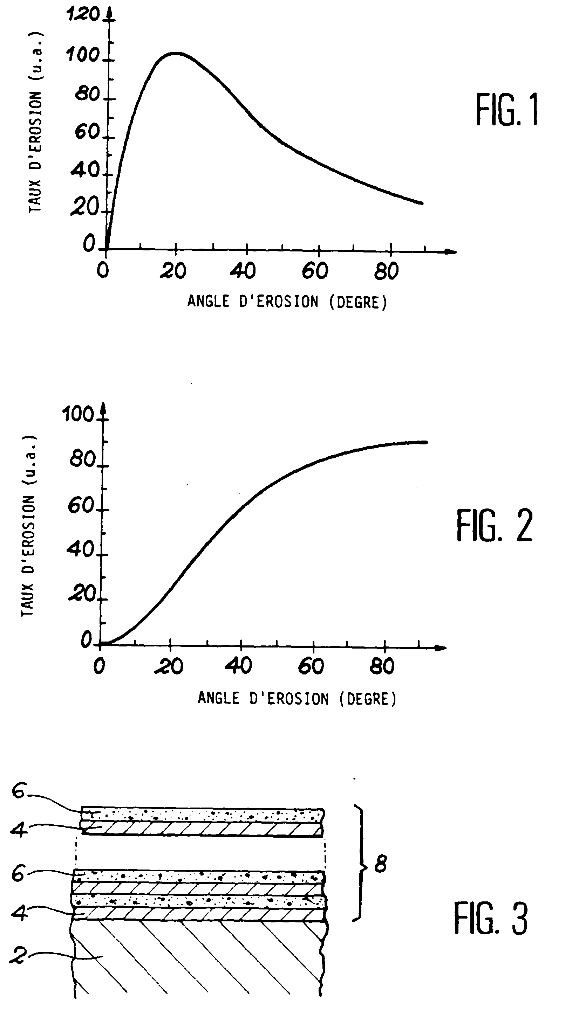

Ces deux comportements sont illustrés respectivement dans les figures 1 et 2 jointes, représentant le taux d'érosion du matériau testé en fonction de l'angle d'incidence des particules érodantes.

Par ailleurs, des études complémentaires réalisées par T. Foley and A. Levy, ("The Effect of Heat Treatment on the Erosion Behavior of Steel", Proceedings of the Conference on Wear of Materials, Reston, VA, avril 11-14, 1983, ASME, 1983, p. 346.), ont montré que la microstructure du matériau joue également un rôle important. Par exemple, le taux d'érosion des aciers se trouvant sous différents états microstructuraux (par exemple l'acier XC75 sous forme de perlite grossière, de perlite fine ou de structure globulisée ou l'acier XC20 sous ses trois formes globulisées) est directement lié à la répartition des phases dures, fragiles et ductiles dans l'alliage, alors que la dureté de ces aciers varie peu avec l'état de la microstructure.

De plus, l'érosion varie également en fonction de la forme, de la taille et de la répartition des précipités recouvrant un substrat. G. Hickey, D. Boone, A. Levy et J. Stiglich, ("Erosion of Conventional and Ultrafine-Grained Materials", Thin Solid Films, 118, 321 (1984)), ont montré que des précipités fins de SiC sur de l'acier présentaient une meilleure résistance à l'érosion qu'une précipitation grossière.

Enfin, le taux d'érosion dépend d'un certain nombre de paramètres liés à la nature de l'érodant (taille et forme des particules érodantes, leur dureté et leur fragilité), ainsi que des conditions de tests, c'est-à-dire la vitesse des particules érodantes et leur angle d'incidence).

En conséquence, il ressort des études précédemment citées que les paramètres pouvant intervenir dans les phénomènes d'érosion et les influencer sont nombreux et qu'il est quelquefois difficile de comparer convenablement le comportement de différents matériaux. Il est également difficile de mettre au point des dispositifs et des procédés de protection de surface contre l'érosion et l'abrasion par des particules érodantes dont la gamme de taille est large et dont les angles d'incidence varient énormément.

Toutefois, afin de répondre à ces problèmes d'érosion, certains matériaux ont déjà été proposés.

C'est ainsi que divers matériaux comme les alliages de métaux réfractaires, les carbures, les nitrures ou les borures par exemple, ont été étudiés et utilisés comme revêtements anti-érosion. Ces matériaux ont été déposés, par exemple, sur des aubes de compresseurs d'avions, par diverses techniques telles que la projection plasma, le procédé CVD (dépôt chimique en phase vapeur), le procédé par arc transféré, le procédé par pulvérisation cathodique ou d'autres techniques de dépôts physiques ou chimiques.

On connaît également un procédé de cémentation dense (connu sous le terme anglais "pack-cementation") qui est couramment utilisé pour revêtir d'aluminium, des aubes en superalliages qui fonctionnent dans un environnement oxydant, corrosif et abrasif. Ce traitement est réalisé à une température supérieure à 1000°C, pendant plusieurs heures et ne peut donc pas être appliqué à des pièces en acier ou en alliages dont les propriétés mécaniques sont altérées par des traitements thermiques à températures élevées.

Dans le but de résoudre ce problème et de développer des procédés de dépôt fonctionnant à basse température et permettant notamment de traiter des matériaux en alliages ferreux, C.L. Yaws et G.F. Wakefield, (Proceedings of the 4th International Conference on Chemical Vapor Deposition, eds. by G.F. Wakefield et J.M. Blocher Jr., (The Electrochemical Society Inc., Pennington, NJ, 1973), p. 173 et p. 577), ont développé un procédé de dépôt de carbonitrure de titane sur les aubes d'un compresseur en acier inoxydable. Le dépôt est obtenu par une réaction chimique à partir de la phase gazeuse TiCl₄-N(CH₃)₃-N₂-H₂ (procédé CVD : dépôt chimique en phase vapeur) entre 600 et 700°C. L'adhérence du carbonitrure sur l'acier est assurée par une fine couche de nickel interposée entre le revêtement et le substrat.

Le brevet US-3 951 612 décrit la réalisation de revêtements anti-érosion en carbure de chrome (Cr₇C₃) sur des aubes de compresseurs en acier ou en alliage de titane recouvertes au préalable d'une couche de nickel. La couche de nickel permet d'améliorer à la fois l'adhérence du revêtement en carbure et les propriétés mécaniques du revêtement composite. Les dépôts de Cr₇C₃ sont réalisés à des températures relativement basses comprises entre 450 et 650°C. Ce procédé est réalisé par décomposition thermique de chrome dicumène, (C₉H₁₂)₂Cr. Selon les auteurs de ce brevet, ce revêtement bi-couche résiste un peu moins bien à l'érosion que le revêtement proposé par G.F. Wakefield mais il est très résistant aux chocs thermiques et aux chocs mécaniques. Ceci constitue une amélioration par rapport au revêtement en carbonitrure de titane qui est plus fragile et plus cassant et qui, en outre, provoque une perte de 30 à 50% sur la résistance en fatigue des pièces revêtues.

Un autre type de revêtement multicouche est décrit dans le brevet EP-A- 366 289, selon lequel la structure protectrice comporte des couches de céramique alternant avec des couches métalliques. La céramique et le métal ont des caractéristiques complémentaires de résistance à l'érosion, l'un étant plutôt fragile tandis que l'autre est plutôt ductile et ce revêtement est supposé conférer au substrat sur lequel il est déposé une bonne résistance à l'érosion et à la corrosion. La concentration des matériaux aux interfaces est progressive afin d'améliorer l'adhérence et l'homogénéité du revêtement. Le revêtement protecteur est déposé sur le substrat par la technique de pulvérisation cathodique, en mode réactif pour le matériau céramique.

Selon ce brevet, la couche métallique est en titane et la couche de céramique est en nitrure de titane. Ce type de revêtement peut apporter une amélioration de la tenue à l'érosion, dans le cas de particules érodantes de taille relativement réduite, aux faibles angles d'impact. Cependant, on a constaté que les matériaux multicouches constitués d'un métal relativement mou, comme le titane et d'une céramique, comme le nitrure de titane, ont une tenue médiocre lors de tests d'érosion effectués aux grands angles d'impact, avec des particules de taille importante et de grande vélocité. Bien que ce phénomène ne soit pas clairement élucidé, on suppose qu'il est dû à la faible dureté du revêtement multicouche résultant de la couche métallique molle, conduisant à une déformation importante, aux fortes énergies, de la céramique qui est fragile par nature.

Un procédé de dépôt voisin d'un procédé CVD et nommé dépôt CNTD (dépôt thermochimique par nucléation contrôlée), est décrit dans les brevets US 4 162 345, US 4 147 820, US 4 040 870 et US 4 153 483. Ces procédés permettent respectivement de réaliser le dépôt sur un substrat, de couches dures contenant du tungstène ou du molybdène et du carbone, de couches dures contenant du titane et du bore, du carbone ou du silicium et de couches dures contenant du titane et du bore. Ces revêtements sont particulièrement résistants à l'érosion. Les dépôts sont généralement effectués à des températures comprises entre 650°C et 1100°C. Les matériaux déposés ont une structure non colonnaire, constituée de petits cristallites qui confèrent à ces revêtements les propriétés mécaniques et la résistance à l'érosion recherchées.

Dans le domaine de l'aviation, les aubes de compresseur se trouvant à des températures inférieures à 450°C sont généralement réalisées en alliages de titane de haute résistance spécifique. L'usage de ces alliages se généralise, bien que leurs propriétés tribologiques et leur résistance à l'usure par l'érosion soient médiocres. Afin d'augmenter leur durée de vie, il est donc nécessaire de protéger ces pièces par un revêtement anti-érosion déposé au-dessous de 400°C afin de ne pas dégrader les propriétés mécaniques de l'alliage de titane. Les auteurs des brevets américains précédemment cités ont proposé (voir D.G. Bhat et R.A. Holzl, "Microstructural Evaluation of CM 500L, a New W-C Alloy Coating Deposited by the Controlled Nucleation Thermochemical Deposition Process", Thin Solid Films, 95, 105 (1982)), un procédé CNDT fonctionnant à une température relative basse comprise entre 350°C et 550°C pour obtenir un revêtement anti-érosion appelé CM 500ML.

Le matériau déposé contient deux phases, une phase de tungstène et une phase de W₃C, la structure est constituée de cristallites de tungstène non colonnaires de faible dimension (quelques centaines de nm) et la phase carbure est dispersée dans cette matrice métallique. La teneur en carbone varie typiquement de 7 à 23% atomique, (0,5 à 1,5 % en masse). Ce matériau présente d'excellentes propriétés anti-érosion.

Le brevet EP-A-411 646 décrit un revêtement multicouche résistant à l'érosion et à l'abrasion, plus particulièrement destiné à la protection contre les impacts de particules de dimensions relativement importantes, comportant une première couche de tungstène et une deuxième couche contenant un mélange de tungstène et de carbure de tungstène.

Un autre revêtement résistant à l'abrasion et à l'érosion est décrit dans le brevet EP-A-328 084. Ce revêtement présente lui aussi une structure composite dans laquelle une couche intermédiaire de tungstène pratiquement pure est déposée sur le substrat sous une couche d'un mélange de tungstène et de carbure de tungstène.

On utilise souvent le tungstène dans les structures de protection en raison de ces propriétés mécaniques spécifiques, et en particulier de sa dureté élevée (1100kg.mm⁻² dans l'échelle Vickers HV) allié à un haut module d'élasticité (406GN.m⁻²), lui conférant une bonne résistance à l'usure érosive.

P.N. Dyer, D. Garg, S. Sunder, H.E. Hintermann et M. Maillat, ("Wear-resistant Coatings Containing Tungsten Carbide Deposited by Low-Temperature CVD", 15th International Conference on Metallurgical Coatings, San Diego, CA, April 1988), décrivent un procédé CNTD permettant de déposer des revêtements anti-érosion à une température inférieure à 500°C. Ces revêtements sont constitués d'un mélange de tungstène et de phases de carbure de tungstène telles que W₂C, W₂C+W₃C ou W₃C. Les auteurs ont étudié et développé des revêments durs, lamellaires constitués de couches de tungstène et de couches WₓC (avec x variant entre 2 et 3), et comprenant des petits cristallites. La composition, la microstructure, la dureté et la taille des cristallites sont contrôlés en faisant varier les paramètres de dépôts et notamment la pression partielle de l'oxyde de méthyle (O(CH₃)₂), dans le mélange de gaz réactifs WF₆-O(CH₃)₂-H₂-Ar. La dureté de ces revêtements est supérieure à celle des carbures purs W₂C et WC fournis dans la littérature.

D. Garg et P.N. Dyer décrivent dans "Tungsten Carbide Erosion Resistant Coating for Aerospace Components", Chemical Vapor Deposition of Refractory Metals and Ceramics, Mat. Res. Soc. Symp. Proc., eds. by T.M. Besmann and B.M. Gallois, vol. 168 (Materials Research Society, Pittsburg, PA, 1990) p. 213, des résultats relatifs à la tenue à l'érosion de revêtements multicouche tungstène-carbure de tungstène, déposés par CNTD. L'alternance des couches de métal et de carbure permet non seulement d'avoir une combinaison d'un matériau ductile et d'un matériau dur, mais également d'obtenir une compensation des contraintes internes qui se développent dans les couches déposées par CNTD. Ceci permet de réaliser des revêtements plus épais tout en limitant les risques de pertes d'adhérence et de décollement des revêtements ; l'épaisseur du revêtement devant en effet être la plus grande possible pour avoir la durée de vie maximale du revêtement anti-érosion. Des expériences ont montré que la résistance de ces revêtements contre l'érosion était supérieure d'un facteur 3 environ à celle des substrats d'acier inoxydable AM-350 non revêtus.

Le document JP-A-60 22 1565 divulgue un revêtement à trois couches comprenant par exemple, une première couche purement métallique réalisée en tungstène, une deuxième couche formée d'un mélange de tungstène métallique et d'un carbure ou d'un nitrure de tungstène et une troisième couche comprenant uniquement du nitrure ou du carbure de tungstène. Toutefois, la tenue à l'érosion de ces matériaux n'est pas satisfaisante.

Le document WO 84/04110 décrit une couche dure obtenue par incorporation d'azote dans du tungstène ou du molybdène et son procédé d'obtention. Toutefois, ce document ne divulgue pas la réalisation d'un empilement de couches dure et ductile pour obtenir un matériau résistant à l'érosion et à l'abrasion.

Le fait que les propriétés mécaniques d'un revêtement à structure modulée en composition peuvent être très différentes de celles des revêtements homogènes en composition est connue depuis un certain nombre d'années. En 1970, J.S. Koehler, (Phys. Rev. B, 2, 547, (1970)) a proposé d'augmenter la résistance mécanique des matériaux en inhibant la mobilité des dislocations grâce à une structure modulée en composition.

L'analyse de ces données de la littérature fait apparaître l'intérêt de mettre au point un procédé permettant de déposer à basse température (inférieure à 400°C) des revêtements anti-érosion et anti-abrasion protégeant des pièces en alliage à faible résistance thermique, des impacts de particules solides telles que le sable, la silice, l'alumine ou les poussières.

A cet effet, l'invention concerne un matériau multicouche comprenant un substrat recouvert d'au moins une couche ductile de tungstène métallique ou d'alliage de tungstène et d'au moins une couche dure d'une solution solide d'un élément d'apport choisi parmi le carbone ou l'azote, dans du tungstène ou dans un alliage de tunsgène, les deux types de couches étant alternés et la teneur en carbone dans la solution solide de carbone dans du tungstène ou dans l'alliage de tungstène est inférieure à 25% atomique, ou la teneur en azote dans la polution solide est comprise entre 0,5 et 15% atomique. De preference, la teneur en carbone est comprise entre 12 et 18% atomique ou mieux encore entre 14 et 15% atomique, tandis que la teneur en azote dans la solution solide d'azote dans du tungstène ou dans un alliage de tungstène est comprise entre 1 et 10% atomique.

Ces matériaux sont stables, microcristallins et durs.

Le réseau cristallin de la solution solide d'élément d'apport dans du tungstène correspond à celui du tungstène métallique qui est très stable thermiquement, puisque la température de fusion du tungstène est voisine de 3400°C.

Cette structure à la fois dure et ductile du matériau multicouche selon l'invention permet d'améliorer la tenue à l'érosion face à une gamme étendue de taille de particules. La dureté élevée est particulièrement intéressante aux faibles angles d'impact des particules érodantes, tandis qu'une bonne ductilité permet de retarder la fissuration du revêtement aux fortes énergies et pour de grandes tailles de particules.

La dureté Vickers de la couche dure de carbone dans le tungstène atteint 26 000 MPa pour une charge de 50 g, lorsque la teneur en carbone dans la solution solide est comprise entre 14 et 15% atomique. A titre de comparaison la dureté Vickers de la couche ductile de tungstène, dans les mêmes conditions est d'environ 13 000 MPa.

Les matériaux constitués d'un empilement de structure bicouche tungstène/solution solide de carbone dans du tungstène, présentent des performances supérieures à celles des revêtements constitués uniquement de la phase carbure WC₁₋ₓ. Ceci est peut être dû au fait que les deux couches, bien qu'ayant des duretés très différentes, ont un réseau cristallin identique, ce qui confère une grande stabilité à l'interface métal/phase carbonée.

La dureté de la solution solide d'azote dans du tungstène est fonction du taux de métalloïde incorporé. Par exemple, la dureté Vickers de la solution solide comprenant 6% atomique d'azote est supérieure à 3500 kgf.mm⁻², soit 34000 MPa sous une charge de 100 g, ( dureté HV 0,1).

Dans le matériau multicouche, le substrat est de préférence un alliage de titane, ou de l'acier inoxydable. Cependant, on pourra aussi choisir la matière du substrat parmi les matériaux suivants : alliages d'aluminium, alliages de nickel, polymères, matériaux composites. Les dépôts peuvent donc être effectués sur des matériaux utilisés couramment, notamment dans l'industrie aéronautique.

L'invention concerne également un revêtement anti-érosion et anti-abrasion comprenant le matériau multicouche précédemment décrit.

Enfin, l'invention concerne également un procédé de fabrication du matériau multicouche précédemment cité, comprenant les étapes consistant à :
- introduire un substrat dans une enceinte de pulvérisation cathodique ou d'évaporation,
- effectuer une pulvérisation cathodique ou une évaporation respectivement à partir d'une cible ou d'une source de tungstène pur ou d'alliage de tungstène dans un plasma constitué alternativement d'un gaz rare et de 0% d'un gaz d'apport ou d'un mélange d'une part d'un gaz rare et d'autre part de 5 à 25% en volume d'un gaz d'apport contenant du carbone ou de 9 à 30% en volume d'un gaz d'apport contenant de l'azote, de façon à déposer alternativement sur le substrat au moins une couche ductile de tungstène métallique ou d'alliage de tungstène et au moins une couche dure d'une solution solide d'élément d'apport dans du tungstène ou dans un de ses alliages.

Ce procédé permet d'effectuer des dépôts à de basses températures sur des substrats constitués par des alliages ou des matériaux peu stables thermiquement comme des alliages d'aluminium, des polymères ou des matériaux composites. En effet, on a pu constater au cours des essais que la température du substrat ne s'élevait que jusqu'à 250 à 270°C au cours du dépôt.

Ce procédé permet de n'utiliser qu'un seul équipement pour déposer des revêtements multicouche sans avoir à remettre à l'air les substrats entre les opérations de dépôt des différentes couches, et en protégeant ainsi les interfaces vis-à-vis de l'oxydation. En outre, ce procédé permet de modifier la composition du revêtement en modifiant simplement la composition du plasma à l'intérieur de l'enceinte de pulvérisation.

Ce procédé permet également de réaliser l'alternance des couches de matériaux avec un procédé fonctionnant sous vide, en n'utilisant que les éléments à incorporer dans les couches, c'est-à-dire le tungstène et l'élément d'apport et en l'absence d'autres éléments chimiques, comme par exemple le fluor, présent dans le procédé CNTD et qui risque de contaminer le revêtement. Cette contamination risque notamment de survenir au niveau des interfaces lors de la modification des paramètres de dépôt pour passer du dépôt d'une couche à l'autre. Cette contamination des interfaces est gênante dans la mesure où des éléments étrangers sont susceptibles de dégrader les propriétés mécaniques des couches et d'être à l'origine de propagation ou d'initiation de fissures ou d'altération de la résistance à la corrosion.

Enfin, ce procédé permet d'automatiser les opérations de chargement et de déchargement des substrats ainsi que les opérations de dépôt.

De façon avantageuse, dans le procédé qui vient d'être décrit la source de tungstène pur ou d'un de ses alliages, utilisée dans la pulvérisation cathodique est une cible du type magnétron.

Ceci permet de déposer le revêtement avec une vitesse supérieure à 2,5 nm/s et d'obtenir des revêtements épais avec un temps de dépôt raisonnable. En outre, ces revêtements sont très adhérents au substrat du fait que les particules éjectées de la cible arrivent sur le substrat avec une énergie cinétique de plusieurs eV, ce qui correspond à une énergie relativement élevée par rapport à celle mise en jeu dans d'autres procédés de dépôt.

L'invention sera mieux comprise à la lecture de la description suivante d'un mode de réalisation de l'invention donnée à titre d'exemple illustratif et non limitatif, cette description étant faite en faisant référence aux dessins joints dans lesquels :
- les figures 1 et 2 sont des courbes illustrant la relation entre le taux d'érosion et l'angle d'incidence des particules érodantes, respectivement pour un matériau ductile du type métal et pour un matériau fragile du type carbure,
- les figures 3 à 6 sont des coupes schématiques de différents modes de réalisation du matériau multicouche selon l'invention,
- la figure 7 représente deux droites C₁ et C₂ illustrant la composition respective en carbone et en tungstène dans une couche dure carbone-tungstène du matériau selon l'invention, en fonction du débit de méthane utilisé dans le plasma lors du dépôt,
- la figure 8 représente la variation de la dureté d'une couche dure de solution solide de carbone dans du tungstène du revêtement selon l'invention, en fonction de la teneur en carbone,
- la figure 9 est un diagramme illustrant le taux d'érosion de deux exemples de matériau multicouche réalisés selon l'invention comparés à des matériaux témoins, l'érosion étant effectuée avec des particules érodantes arrivant sur la surface dudit matériau selon un angle d'incidence de 90°,
- la figure 10 est similaire à la figure 9 sauf en ce qui concerne l'angle d'incidence qui est de 45°, et
- la figure 11 est un diagramme similaire à la figure 9 mais réalisé dans des conditions d'érosion légèrement différentes, et
- la figure 12 est similaire à la figure 11, sauf que l'angle d'incidence est de 30°.

Comme illustré en figure 3, le matériau multicouche selon l'invention comprend un substrat 2 recouvert d'une alternance de couches ductiles 4 en tungstène ou en alliage de tungstène et de couches dures 6 d'une solution solide d'un élément d'apport dans du tungstène ou dans un alliage de tungstène. Cette alternance de couches ductiles et de couches dures forme un revêtement référencé globalement 8. Cet élément d'apport est choisi parmi le carbone, ou l'azote.

L'alliage de tungstène qui peut être utilisé dans la couche ductile 4 ou dans la couche dure 6 est un alliage constitué de tungstène et d'un ou de plusieurs autres éléments choisis parmi le titane, le zirconium, le hafnium, le vanadium, le niobium, le tantale, le chrome, le molybdène, le nickel, le cuivre, l'aluminium, le cobalt, le fer, le platine et le palladium.

Comme cela a été décrit précédemment, la teneur en carbone dans la solution solide 6 de carbone dans du tungstène ou dans un alliage de tungstène est inférieure à 25% atomique, de préférence comprise entre 12 et 18% atomique ou mieux entre 14 et 15% atomique. La teneur en azote dans la solution solide 6 d'azote dans du tungstène ou dans un alliage de tungstène est comprise entre 0,5 et 15% atomique et de préférence entre 1 et 10% atomique.

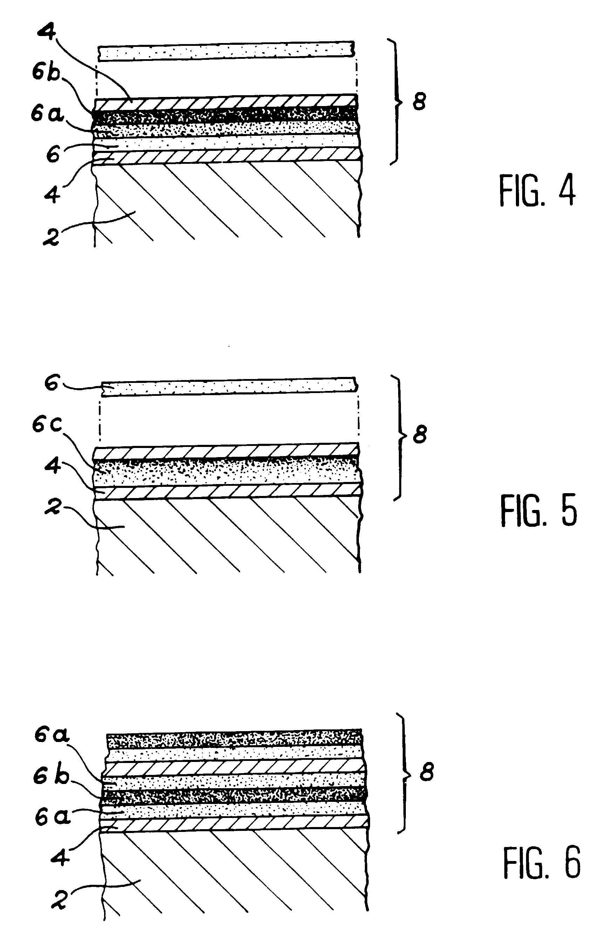

La figure 4 illustre un second mode de réalisation du matériau multicouche selon l'invention. Dans ce cas, celui-ci comprend successivement et en alternance, une couche ductile 4 de tungstène ou d'alliage de tungstène et au moins deux couches dures d'une solution solide d'un élément d'apport dans le tungstène (ou l'un de ses alliages). On a représenté ici trois couches dures qui sont référencées 6, 6a, 6b et qui présentent des teneurs en éléments d'apport constantes à l'intérieur de chaque couche respective mais croissantes dans la totalité de l'ensemble de trois couches dures successives. Ici, la teneur est croissante entre le substrat 2 et l'extérieur du revêtement. En d'autres termes, la couche dure 6 la plus proche du substrat 2 a la teneur en élément d'apport la plus faible et la couche 6b la teneur la plus élevée.

On notera que l'ordre de la superposition de couches pourrait être inversé, la couche 6b étant alors placée au voisinage du substrat 2 et la couche 6 la plus à l'extérieur du revêtement. Le choix de l'ordre des couches est fonction de l'application recherchée.

La figure 5 illustre une variante de réalisation proche de celle de la figure 4, dans laquelle au moins l'une des couches dures présente intérieurement un gradient croissant d'élément d'apport dans la solution solide, la partie de ladite couche dure comprenant la plus faible teneur en élément d'apport étant dirigée vers le substrat 2, (ou éventuellement inversement). Cette couche dure présentant un gradient croissant est référencée 6c.

Enfin, la figure 6 illustre un quatrième mode de réalisation du matériau multicouche selon l'invention. Dans ce cas, le substrat 2 est revêtu d'une première couche de tungstène ou d'alliage de tungstène 4 sur laquelle sont déposées successivement trois couches de solution solide 6a, 6b, 6a, la teneur en élément d'apport étant constante à l'intérieur de chaque couche dure, mais deux couches dures successives ayant des teneurs différentes en élément d'apport. Ainsi, la teneur en élément d'apport de la couche intermédiaire 6b est plus élevée que celle des deux couches 6a placées de part et d'autre. Sur cet ensemble enfin, est déposée une deuxième couche de tungstène 4 ou d'alliages de tungstène, revêtue éventuellement d'autres couches 6a et 6b. On a ainsi réalisé à titre d'exemple, des substrats présentant une couche de tungstène recouverte de trois couches de solutions solides d'azote dans du tungstène dans lesquelles les teneurs en azote étaient respectivement de 3%, 6% et 3% atomique.

De préférence, bien que cela ne soit pas une caractéristique limitative de l'invention, la couche ductile de tungstène ou d'alliage de tungstène 4 est disposée directement au contact du substrat 2, tandis que la couche externe du revêtement est une couche de solution solide d'un élément d'apport dans le tungstène ou l'un de ses alliages.

Le nombre de couches, l'épaisseur de chaque couche et l'épaisseur totale du revêtement anti-érosion et anti-abrasion 8 ainsi formé, ainsi que la concentration en élément d'apport des couches dures 6 de solution solide, sont choisis en fonction du degré de protection contre l'abrasion et l'érosion recherchées et en fonction de l'application envisagée.

L'épaisseur totale du revêtement anti-érosion et anti-abrasion appliquée sur le substrat peut être comprise entre 5 µm et 200 µm et de préférence entre 10 µm et 100 µm. Le nombre de couches peut être compris entre 2 et 500 et l'épaisseur de chaque couche ductile 4 et dure 6 peut être comprise entre 0,01µm et 50 µm, de préférence entre 0,05µm et 25µm ou mieux entre 0,2 µm et 15 µm. A titre d'exemple, dans les applications les plus courantes de protection contre l'érosion, l'épaisseur totale est généralement comprise entre 40 et 80 µm.

Le dépôt successif des couches ductiles 4 de tungstène et des couches dures 6 est réalisé sur un substrat 2, par exemple poli à la pâte de diamant. Le dépôt s'effectue de préférence sous une pression réduite, par exemple dans une enceinte à basse pression équipée d'un dispositif de mise en phase vapeur de type connu, tel qu'un système de bombardement par faisceau d'électrons ou de pulvérisation cathodique.

Ce dispositif peut fonctionner avec ou sans champ magnétique, en mode diode ou triode, être alimenté en courant continu ou alternatif, en combinaison avec un champ électrique établi entre le substrat 2 et la source de tungstène ou d'alliage de tungstène, dans les conditions de pression engendrant un plasma. Dans le cas d'un dépôt par pulvérisation cathodique, on utilise généralement une cible plane de tungstène pur ou d'alliage de tungstène, de préférence du type magnétron.

Ce dépôt par évaporation ou pulvérisation cathodique s'effectue dans un plasma constitué alternativement d'un gaz rare (par exemple l'argon) ou d'un mélange d'un gaz rare et d'un gaz d'apport, ce dernier étant choisi parmi un gaz contenant du carbone ou de l'azote, suivant que l'on veut obtenir le dépôt d'une solution solide respectivement de carbone ou d'azote dans du tungstène ou l'un de ses alliages. Le gaz contenant du carbone est de préférence un hydrocarbure et notamment le méthane. Il est également à la portée de l'homme de l'art d'introduire un gaz d'apport contenant du carbone et de l'azote simultanément, afin de déposer une solution solide mixte contenant du carbone et de l'azote comme éléments d'apport.

On procède sous une pression de gaz rare comprise de préférence entre 0,1 et 10 Pa par exemple, (par exemple 0,3 Pa) et une pression partielle d'azote ou de méthane comprise de préférence entre 0,01 et 1 Pa suivant la nature du dépôt que l'on souhaite obtenir. Cette pression est déterminée en fonction de la densité de puissance appliquée sur la source de dépôt et de la distance source/substrat.

Compte tenu du volume de l'enceinte et de la dimension de la source de pulvérisation cathodique ou de la source d'évaporation, les divers réglages tels que la distance du substrat 2 par rapport à la source sont effectués suivant des techniques usuelles. Il est nécessaire de tenir compte de la pression partielle du gaz utilisé pour une densité de puissance appliquée sur la source et de contrôler par une analyse cristallographique le produit obtenu, afin d'éviter la formation d'une phase de carbure ou de nitrure.

Lorsque l'on souhaite former un matériau multicouche, avec une solution solide de carbone dans du tungstène, on fait varier la teneur en méthane entre 0% pour déposer une couche de tungstène ou d'alliage de tungstène 4 et entre des valeurs supérieures à 5% et inférieures à 25% en volume pour déposer la couche dure 6 suivante. Dans les essais réalisés, le débit d'argon était de 50 cm³/min et celui de méthane variait entre 4 et 15 cm³/min. L'introduction du méthane dans l'enceinte de pulvérisation afin de déposer la couche dure 6 provoque une augmentation de la pression totale qui passe alors à 6.10⁻¹ Pa, lorsque le plasma argon-méthane contient 50% de méthane.

En effet, contrairement à l'art antérieur où l'on effectuait des dépôts en présence d'argon et d'acétylène, on a découvert que l'emploi de méthane permettait d'obtenir des teneurs en carbone dans le tungstène très faibles.

Lorsque dans les essais réalisés, on a cherché à former un matériau multicouche avec une solution solide d'azote dans du tungstène, on a fait varier la teneur en azote dans le plasma entre 0% pour déposer une couche de tungstène ou d'alliage de tungstène 4 et entre des valeurs supérieures à 9% et inférieures à 30% pour déposer la couche dure 6 suivante. Dans ces essais, le débit d'azote variait entre 10 et 40 cm³/min et celui d'argon était voisin de 100 cm³/min.

La densité de puissance moyenne de pulvérisation est de préférence comprise entre 6 et 12 W/cm² pour une cible magnétron et le substrat 2 est polarisé à -100 V. Le substrat 2 n'est pas chauffé volontairement, toutefois on a pu constater que sa température qui était d'environ 150°C durant le traitement de surface passe à 250°C à 270°C durant l'étape de dépôt.

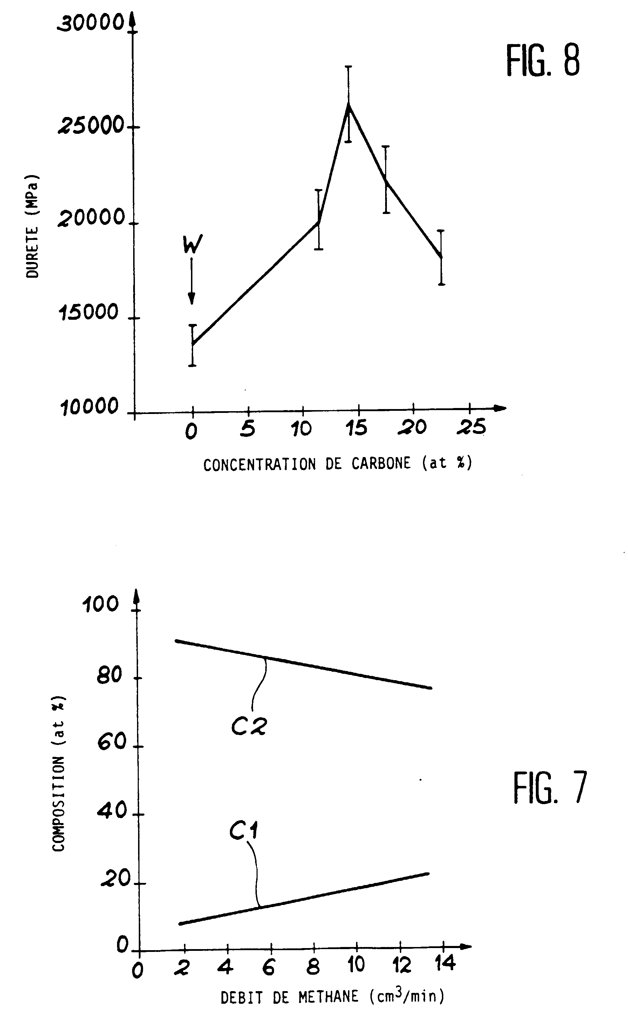

Certaines mesures plus spécifiques ont été réalisées lors du dépôt d'une solution solide de carbone dans du tungstène. Comme illustré en figure 7, la teneur en carbone (courbe C₁) dans la couche 6 déposée sur le substrat augmente linéairement lorsque le débit de méthane introduit dans le plasma augmente. Inversement, la teneur en tungstène (courbe C₂) diminue. En faisant varier la teneur en méthane dans le plasma argon-méthane, on peut ainsi obtenir deux types de matériaux tungstène-carbone. Lorsque la teneur en méthane est inférieure à 25% dans le plasma argon-méthane, la teneur en carbone dans la couche dure 6 est inférieure à 25% atomique. Au contraire, lorsque la teneur en méthane dans le plasma est comprise entre 25 et 50%, la teneur en carbone du matériau tungstène-carbone passe alors de 30% atomique à 65% atomique.

Toutefois, seul le premier matériau obtenu comprenant moins de 25% atomique de carbone, est intéressant dans l'invention. La structure cristallographique du premier matériau obtenu mesurée par diffraction aux rayons X correspond à celle du tungstène métallique en phase α. Néanmoins, le paramètre de maille du réseau cubique, calculé à partir des spectres de diffraction, est supérieur à celui de la maille de tungstène métallique, fournie dans la littérature. La dilatation du paramètre de maille augmente jusqu'à 3% lorsque la teneur en carbone dans la couche atteint 15% atomique. C'est pourquoi, on peut admettre que la couche 6 contenant moins de 25% atomique de carbone est une solution solide de carbone dans le tungstène. On observera que la dilatation du paramètre de maille peut être due également à l'existence de contraintes mécaniques internes. La dilatation du réseau cristallin du métal peut résulter d'une combinaison de ces deux effets.

La dureté Vickers de la couche dure 6 augmente progressivement avec la teneur en carbone comme cela est illustré en figure 8. Ainsi, sous une charge de 50 g, cette dureté atteint un pic de 26 000 MPa, pour une solution solide de carbone dans du tungstène contenant environ 15% atomique de carbone. Au-delà de 15% atomique de carbone, la dureté du revêtement diminue lorsque la teneur en carbone augmente.

A titre d'exemple purement illustratif, on donnera ci-après plusieurs exemples de réalisation d'un matériau multicouche selon l'invention, ainsi que des résultats de tests d'érosion effectués sur certains de ces matériaux.

### Matériau multicouche avec des solutions solides contenant du carbone :

On a réalisé le dépôt des bicouches 4 et 6 selon l'invention sur un substrat en alliage de titane TA6V, en utilisant la technique de dépôt par pulvérisation cathodique décrite précédemment. Les couches dures 6 étaient formées par une solution solide de carbone dans du tungstène. La teneur en carbone dans la solution solide 6 était de 15% atomique, ce qui correspond à la dureté maximale de 26 000 MPa. L'épaisseur totale du revêtement 8 était de 60 µm environ. Deux variantes ont été réalisées :

### Exemple 1

L'épaisseur des couches élémentaires de tungstène 4 ou de solution solide 6 à 15% atomique de carbone était de 10 µm et l'on a déposé au total 6 couches.

### Exemple 2

L'épaisseur des couches élémentaires de tungstène 4 ou de solution solide 6 à 15% atomique de carbone était de 5 µm et l'on a déposé un nombre total de 12 couches.

### Tests d'érosion effectués sur les exemples 1 et 2, sur le TA6V et sur un exemple comparatif :

### Exemple comparatif 1

Un exemple comparatif a été réalisé en effectuant le dépôt successif de couches de tungstène pur et de carbure de tungstène. L'épaisseur des couches élémentaires de tungstène et de carbure de tungstène à 40% atomique de carbure était de 5 µm et l'on a déposé un nombre total de 12 couches. Le substrat était également l'alliage de titane TA6V.

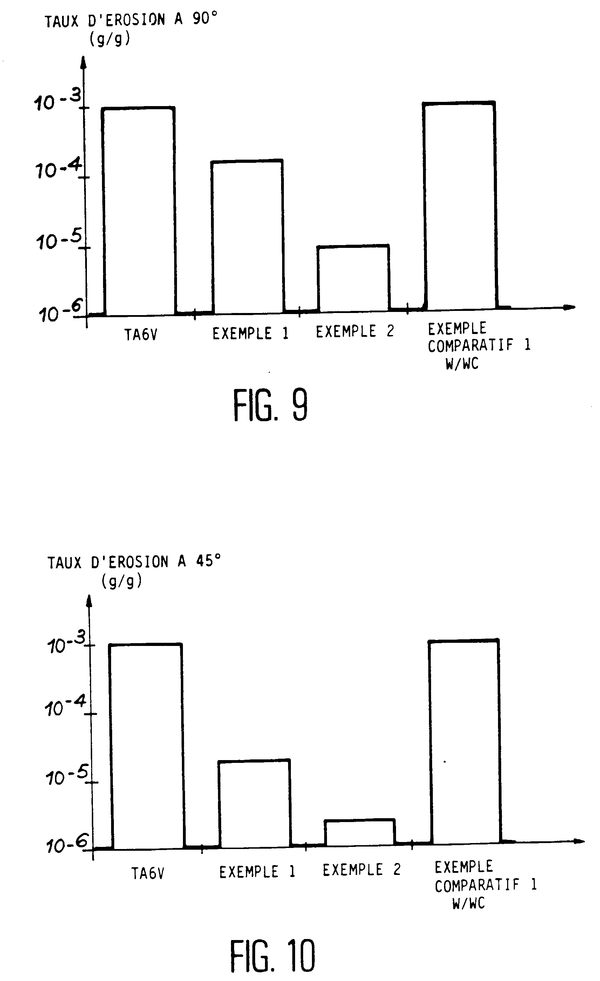

Ensuite, les matériaux multicouches réalisés selon les trois exemples précités et le TA6V ont été soumis à des tests d'érosion dont les résultats sont donnés sur les figures 9 et 10. Les valeurs du taux d'érosion sont exprimées par le rapport entre la masse de revêtement perdue par érosion et la masse de particules érodantes utilisée dans ce test. Plus le taux d'érosion est faible et meilleur est l'échantillon testé. Ces tests d'érosion ont été effectués selon deux angles d'incidence des particules érodantes, respectivement 90° et 45°, représentés respectivement sur les figures 9 et 10. L'érodant était du quartz en grains de taille 160 µm, le débit de l'érodant était de 6 g/min et la vitesse de l'air porteur était de 240 m/s.

Le taux d'érosion du substrat en alliage TA6V nu (sans revêtement) est égal ou supérieur à 10⁻³ g/g pour les angles d'incidence de 90° et 45°. Il en est de même pour le taux d'érosion du matériau de tungstène/carbure de tungstène de l'exemple comparatif 1.

Comme on peut le constater sur les figures 9 et 10, le revêtement multicouche réalisé selon l'exemple 1 permet d'améliorer la résistance à l'érosion d'un facteur 10 ou 100 par rapport au TA6V seul, suivant que l'angle d'incidence des particules érodantes est respectivement de 90° ou 45°. Le revêtement multicouche correspondant à l'exemple 2 permet quant à lui d'améliorer la résistance à l'érosion d'un facteur 100 ou environ 200 suivant que l'angle d'incidence des particules est de 90° ou de 45°. Ce deuxième revêtement est donc encore meilleur que le premier et présente des performances très supérieures aux revêtements tungstène/carbure de tungstène de l'exemple comparatif 1.

### Matériau multicouche avec des solutions solides contenant de l'azote

### Exemple 3

On utilise un équipement de dépôt sous vide, équipé d'une source de pulvérisation cathodique magnétron plan, munie d'une cible en tungstène de pureté 99,5ο. Les substrats en acier ou en alliage de titane, reliés au pôle négatif d'un générateur de courant continu, sont disposés en regard de la source à une distance de 9 cm.

Après avoir obtenu dans l'enceinte de dépôt une pression inférieure à 8x10⁻⁴ Pa, on introduit de l'argon jusqu'à une pression de 0,3 Pa. On effectue alors un décapage par pulvérisation cathodique du substrat sous une tension de -200 V pendant 30 min et de la source de dépôt avec une densité de puissance de 12 W.cm⁻² pendant 10 minutes.

Aux termes de ces deux opérations effectuées en recouvrement, on effectue en séquence le revêtement du substrat. La tension de polarisation du substrat est réduite à -100 V et la densité de puissance appliquée sur la source reste inchangée. Dans ces conditions, on obtient une couche de tungstène d'épaisseur 2 µm en 6 minutes, soit une vitesse de dépôt de 5,5 nm.s⁻¹.

Lorsque l'épaisseur désirée de la couche de tungstène est atteinte, on introduit en séquence un flux d'azote jusqu'à l'obtention d'une pression partielle de 0,045 Pa, correspondant à un flux d'azote de 50 standard cm³ minute⁻¹ (50 sccm), la pression partielle d'argon, 0,3 Pa, et la densité de puissance appliquée sur la source, 12 W.cm⁻², étant inchangées. Ces paramètres conduisent à la formation d'une couche de solution solide tungstène-azote d'épaisseur 2 µm en 8 minutes, soit une vitesse de dépôt de 4,2 nm s⁻¹.

Le flux d'azote est alors stoppé et la séquence est répétée 14 fois, jusqu'à l'obtention d'un revêtement multicouche d'épaisseur totale 56 µm.

### Exemple 4

Le substrat en alliage de titane (TA6V) et la source de pulvérisation étant nettoyés, on opère avec une pression partielle d'argon de 0,2 Pa et une densité de puissance à la source de 12 W.cm⁻².

La première couche de tungstène pur d'une épaisseur de 12 µm est déposée en atmosphère d'argon pur, à une vitesse de 5,5 nm.s⁻¹.

La deuxième couche de solution solide d'azote de 12 µm d'épaisseur est déposée en présence d'une pression partielle d'azote de 0,006 Pa, soit un flux d'azote de 10 sccm, à une vitesse de 5,4 nm.s⁻¹.

La troisième couche de solution solide d'azote de 12 µm d'épaisseur est déposée avec un flux d'azote de 20 sccm, correspondant à une pression partielle d'azote de 0,016 Pa, à une vitesse de 5 nm.s⁻¹.

La quatrième couche de solution solide d'azote d'épaisseur 12 µm est déposée avec un flux d'azote de 30 sccm, correspondant à une pression partielle d'azote de 0,025 Pa, à une vitesse de 4,7 nm.s⁻¹.

La cinquième couche de solution solide d'azote d'épaisseur 12 µm est déposée avec un flux d'azote de 40 sccm, correspondant à une pression partielle d'azote de 0,035 Pa, à une vitesse de 4,4 nm.s⁻¹.

Avec une telle séquence de dépôt, on obtient un revêtement d'épaisseur totale de 60 µm à gradient de composition et donc de propriétés mécaniques incrémentées.

### Exemple 5

On a réalisé un revêtement identique à celui de l'exemple 4 sauf que l'on a interposé entre chaque couche de solution solide tungstène-azote, une couche de tungstène d'épaisseur 0,5 µm.

### Exemple 6

Le substrat et la source de pulvérisation étant nettoyés, on opère avec une pression partielle d'argon de 0,3 Pa et une densité de puissance source de 12 W.cm⁻².

La première couche de tungstène d'une épaisseur de 10 µm est déposée en atmosphère d'argon pur, à une vitesse de 5,5 nm.s⁻¹.

La deuxième couche de solution solide de 5 µm d'épaisseur est déposée en présence d'une pression partielle d'azote de 0,016 Pa, soit un flux d'azote de 20 sccm, à une vitesse de 5 nm.s⁻¹.

La troisième couche de solution solide de 10 µm d'épaisseur est déposée avec un flux d'azote de 50 sccm, correspondant à une pression partielle d'azote de 0,045 Pa, à une vitesse de 4,2 nm.s⁻¹.

La quatrième couche de solution solide de 5 µm d'épaisseur est déposée en présence d'une pression partielle d'azote de 0,016 Pa, soit un flux d'azote de 20 sccm, à une vitesse de 5 nm.s⁻¹.

Cette séquence est répétée deux fois pour l'obtention d'un revêtement multicouche d'épaisseur 60 µm.

### Exemple 7

On utilise un équipement de dépôt équipé d'une source d'évaporation par faisceau d'électrons, d'une puissance électrique de 15 kW. On procède au remplissage du creuset d'évaporation, de contenance 60 cm³, avec des pastilles de tungstène de diamètre 20 mm et d'épaisseur 5 mm. Les substrats sont placés au-dessus de la source d'évaporation, à une distance de 30 cm.

Aux termes de la procédure de mise sous vide de l'enceinte de dépôt et de nettoyage des substrats par bombardement ionique, on procède à la phase de dépôt proprement dite. La tension de polarisation appliquée aux substrats est réduite à -100 V et la pression d'argon à 0,2 Pa. On augmente régulièrement, manuellement ou au moyen d'un dispositif automatique, la puissance du faisceau d'électrons jusqu'à 10 kW, de façon à obtenir progressivement la fusion du tungstène puis l'évaporation.

La première couche en tungstène pur d'épaisseur 2 µm est déposée à une vitesse de 6 nm.s⁻¹.

La deuxième couche de 4 µm d'épaisseur est élaborée en mode réactif en présence d'un flux d'azote de 40 sccm. La pression partielle d'azote est maintenue à une valeur de 0,04 ± 0,001 Pa, en ajustant la puissance du faisceau d'électrons.

La séquence est répétée 5 fois pour l'obtention d'un revêtement d'épaisseur 30 µm.

### Exemple 8

On procède comme dans l'exemple 6, mais en utilisant comme source un alliage tungstène-chrome à 3% atomique de chrome, en opérant avec une pression partielle d'argon de 0,4 Pa et une densité de puissance de 11 W cm⁻².

La première couche (tungstène pur) d'une épaisseur de 10 µm est déposée en atmosphère d'argon pur, à une vitesse de 5,6 nm.s⁻¹.

Les deuxième, troisième et quatrième couches sont déposées comme indiqué dans l'exemple 6, mais l'épaisseur de la quatrième couche est de 10 µm.

La séquence est répétée deux fois pour obtenir un revêtement multicouche de 70 µm.

### Tests d'érosion effectués sur les exemples 2 et 5, sur le TA6V et sur l'exemple comparatif 2

### Exemple comparatif 2

Le substrat en alliage de titane (TA6V) était recouvert d'une monocouche de TiN de 60 µm d'épaisseur.

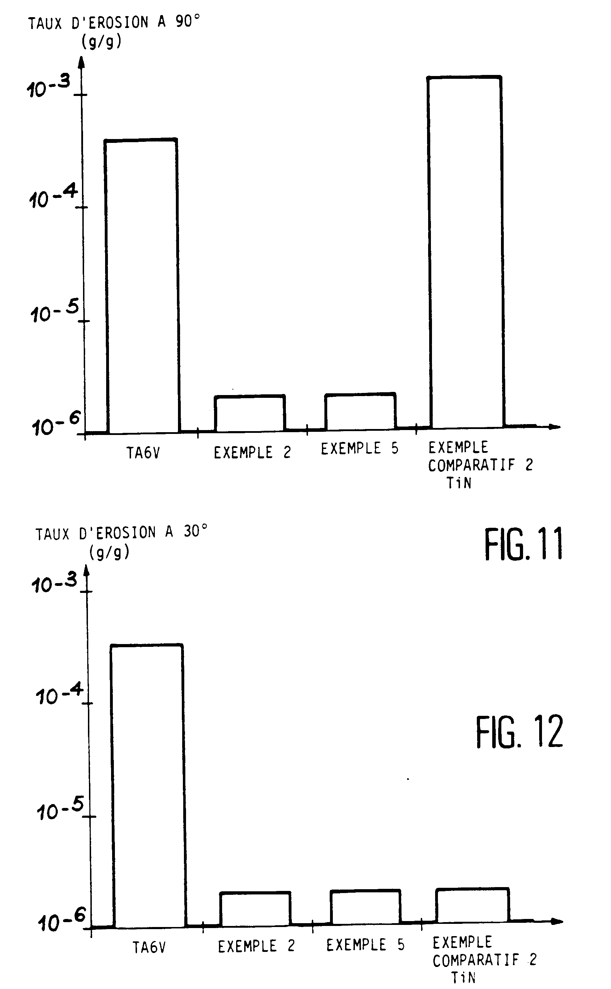

Ensuite, l'alliage de TA6V nu et les matériaux réalisés selon les exemples 2 et 5 et l'exemple comparatif 2 ont été soumis à des tests d'érosion dont les résultats sont donnés sur les figures 11 et 12. Ces tests d'érosion ont été effectués dans les mêmes conditions que le test d'érosion précédemment décrit si ce n'est que l'érodant est ici du quartz en grains de taille 600 µm et que le débit de l'érodant est de 2 g/min. Ces tests d'érosion ont été effectués selon deux angles d'incidence des particules érodantes, respectivement 90 et 30°, représentés respectivement sur les figures 11 et 12.

Comme on peut le constater sur la figure 11, le revêtement multicouche réalisé selon les exemples 2 et 5 permet d'améliorer la résistance à l'érosion d'un facteur d'environ 200 par rapport au TA6V et d'environ 300 par rapport au TiN.

Comme on peut le constater sur la figure 12, le revêtement multicouche réalisé selon les exemples 2 et 5 permet d'améliorer la résistance à l'érosion d'un facteur d'environ 150 par rapport au TA6V et est identique au TiN.

## Revendications

1. Matériau multicouche, caractérisé en ce qu'il comprend un substrat (2) recouvert d'au moins une couche ductile (4) de tungstène métallique ou d'alliage de tungstène et d'au moins une couche dure (6, 6a, 6b, 6c) d'une solution solide d'un élément d'apport choisi parmi le carbone ou l'azote, dans du tungstène ou dans un alliage de tungstène, les deux types de couches (4) et (6, 6a, 6b, 6c) étant alternées et en ce que la teneur en carbone dans la solution solide (6, 6a, 6b, 6c) est inférieure à 25% atomique ou la teneur en azote dans la solution solide (6, 6a, 6b, 6c) est comprise entre 0,5 et 15% atomique.

2. Matériau multicouche selon la revendication 1, caractérisé en ce que la couche dure (6, 6a, 6b, 6c) est une solution solide mixte de carbone et d'azote dans du tungstène ou dans un alliage de tungstène.

3. Matériau multicouche selon la revendication 1, caractérisé en ce que la teneur en carbone dans la solution solide (6, 6a, 6b, 6c) est comprise entre 12 et 18% atomique.

4. Matériau multicouche selon la revendication 1, caractérisé en ce que la teneur en carbone dans la solution solide (6, 6a, 6b, 6c) est comprise entre 14% et 15% atomique.

5. Matériau multicouche selon la revendication 1, caractérisé en ce que la teneur en azote dans la solution solide (6, 6a, 6b, 6c) est comprise entre 1 et 10% atomique.

6. Matériau multicouche selon l'une quelconque des revendications précédentes, caractérisé en ce qu'il comprend au moins deux couches dures (6, 6a, 6b) successives de solution solide présentant des teneurs en élément d'apport constantes à l'intérieur de chaque couche dure (6), des couches dures successives ayant des teneurs différentes en élément d'apport.

7. Matériau multicouche selon la revendication 6, caractérisé en ce que les couches dures (6, 6a, 6b) successives de solution solide présentent des teneurs en élément d'apport constantes à l'intérieur de chaque couche dure et croissantes dans la totalité d'un ensemble de couches dures successives.

8. Matériau multicouche selon la revendication 7, caractérisé en ce que la couche dure (6) la plus proche du substrat (2) a la teneur en élément d'apport la plus faible de la totalité de l'ensemble des couches dures (6, 6a, 6b) successives.

9. Matériau multicouche selon l'une quelconque des revendications précédentes, caractérisé en ce qu'au moins l'une des couches dures (6c) présente intérieurement un gradient croissant d'élément d'apport dans la solution solide, la partie de ladite couche dure comprenant la plus faible teneur en élément d'apport étant dirigée vers le substrat (2).

10. Matériau multicouche selon la revendication 1, caractérisé en ce que l'alliage de tungstène utilisé dans la couche ductile (4) et/ou dans la couche dure (6, 6a, 6b, 6c) est un alliage constitué de tungstène et d'un ou de plusieurs autres éléments choisis parmi le titane, le zirconium, le hafnium, le vanadium, le niobium, le tantale, le chrome, le molybdène, le nickel, le cuivre, l'aluminium, le cobalt, le fer, le platine et le palladium.

11. Matériau multicouche selon la revendication 1, caractérisé en ce que le substrat (2) est choisi parmi un alliage de titane, de l'acier inoxydable, un alliage d'aluminium, un alliage de nickel, des polymères ou des matériaux composites.

12. Matériau multicouche selon la revendication 1, caractérisé en ce que l'épaisseur de chaque couche ductile (4) et dure (6, 6a, 6b, 6c) est comprise entre 0,01 µm et 50 µm, de préférence entre 0,05 et 25 µm, ou mieux encore entre 0,2 et 15 µm.

13. Revêtement anti-érosion et anti-abrasion, caractérisé en ce qu'il comprend un matériau multicouche sleon l'une quelconque des revendications 1 à 12.

14. Procédé de fabrication du matériau multicouche selon l'une quelconque des revendications 1 à 12, par dépôt sous vide en phase vapeur sur un substrat, caractérisé en ce qu'il comprend les étapes consistant à :
- introduire un substrat (2) dans une enceinte de pulvérisation cathodique ou d'évaporation,
- effectuer une pulvérisation cathodique ou une évaporation respectivement à partir d'une cible ou d'une source de tungstène pur ou d'alliage de tungstène, dans un plasma constitué alternativement d'un gaz rare et de 0% d'un gaz d'apport ou d'un mélange d'une part d'un gaz rare et d'autre part de 5 à 25% en volume d'un gaz d'apport contenant du carbone ou de 9 à 30% en volume d'un gaz d'apport contenant de l'azote, de façon à déposer alternativement sur le substrat (2) au moins une couche ductile (4) de tungstène métallique ou d'alliage de tungstène et au moins une couche dure (6) d'une solution solide d'élément d'apport dans du tungstène ou dans un de ses alliages.

15. Procédé de fabrication selon la revendication 14, caractérisé en ce que le gaz contenant du carbone est un hydrocarbure.

16. Procédé de fabrication selon la revendication 15, caractérisé en ce que l'hydrocarbure est le méthane.

## Patentansprüche

1. Mehrschichtenmaterial, **dadurch gekennzeichnet,** daß es ein Substrat (2) umfaßt, überdeckt durch wenigstens eine duktile bzw. formbare metallische Schicht (4) aus Wolfram oder einer Wolframlegierung und wenigstens eine harten Schicht (6, 6a, 6b, 6c) aus einer festen Lösung eines Zusatzelements, ausgewählt zwischen Kohlenstoff und Stickstoff, in Wolfram oder einer Wolframlegierung, wobei die beiden Schichttypen (4) und (6, 6a, 6b, 6c) sich abwechseln, und dadurch, daß der Kohlenstoffgehalt in der festen Lösung (6, 6a, 6b, 6c) kleiner ist als 25 Atom-% oder der Stickstoffgehalt in der festen Losung enthalten ist zwischen 0,5 und 15 Atom-%.

2. Mehrschichtenmaterial nach Anspruch 1,
dadurch gekennzeichnet, daß die harte Schicht (6, 6a, 6b, 6c) eine gemischte feste Lösung aus Kohlenstoff und Stickstoff in Wolfram oder einer Wolframlegierung ist.

3. Mehrschichtenmaterial nach Anspruch 1,
dadurch gekennzeichnet, daß der Kohlenstoffgehalt in der festen Lösung (6, 6a, 6b, 6c) enthalten ist zwischen 12 und 18 Atom-%.

4. Mehrschichtenmaterial nach Anspruch 1,
dadurch gekennzeichnet, daß der Kohlenstoffgehalt in der festen Lösung (6, 6a, 6b, 6c) enthalten ist zwischen 14 und 15 Atom-%.

5. Mehrschichtenmaterial nach Anspruch 1,
dadurch gekennzeichnet, daß der Stickstoffgehalt in der festen Losung (6, 6a, 6b, Gc) enthalten ist zwischen 1 und 10 Atom-%.

6. Mehrschichtenmaterial nach einem der vorangehenden Anspruche, dadurch gekennzeichnet, daß es wenigstens zwei aufeinanderfolgende harte Schichten (6, 6a, 6b) aus fester Lösung umfaßt, die innerhalb jeuer harten Schicht (6) konstante Zusatzelementgehalte aufweisen, wobei aufeinanderfolgende harte Schichten unterschiedliche Zusatzelementgehalte haben.

7. Mehrschichtenmaterial nach Anspruch 6,
dadurch gekennzeichnet, daß die aufeinanderfolgenden harten Schichten (6, 6a, 6b) aus fester Losung Zusatzelementgehalte aufweisen, die innerhalb jeder harten Schicht (6) konstant sind und in der Gesamtheit eines Aufbaus aus aufeinanderfolgenden harten Schichten zunehmend sind.

8. Mehrschichtenmaterial nach Anspruch 7,
dadurch gekennzeichnet, daß die harte Schicht (6), die sich am nächsten bei dem Substrat (2) befindet, den kleinsten Zusatzelementgehalt des gesamten Aufbaus aus aufeinanderfolgenden harten Schichten (6, 6a, 6b) hat.

9. Mehrschichtenmaterial nach einer der vorangehenden Ansprüche, dadurch gekennzeichnet, daß wenigstens eine der harten Schichten (6c) im Innern einen ansteigenden Zusatzelement-Gradienten in der festen Lösung aufweist, wobei der Teil der genannten Schicht, die den kleinsten Zusatzelementgehalt umfaßt, gegen das Substrat (2) gerichtet ist.

10. Mehrschichtenmaterial nach Anspruch 1,
dadurch gekennzeichnet, daß die in der duktilen Schicht 4 und/oder der harten Schicht (6, 6a, 6b, 6c) verwendete Wolframlegierung eine Legierung ist, die gebildet wird durch Wolfram und ein oder mehrere andere Elemente, ausgewählt unter Titan, Zirkonium, Hafnium, Vanadium, Niobium, Tantal, Chrom, Molybdän, Nickel, Kupfer, Aluminium, Kobalt, Eisen, Platin und Palladium.

11. Mehrschichtenmaterial nach Anspruch 1,
dadurch gekennzeichnet, daß das Substrat (2) ausgewählt wird unter einer Titanlegierung, nichtoxidierbarem Stahl, einer Aluminiumlegierung, einer Nickellegierung, Polymeren oder Verbundmaterialien.

12. Mehrschichtenmaterial nach Anspruch 1,
dadurch gekennzeichnet, daß die Dicke jeder duktilen (4) und harten (6, 6a, 6b, 6c) Schicht enthalten ist zwischen 0,05 und 25 µm, oder noch besser zwischen 0,2 und 15µm.

13. Antierosions- und Antiabrasions-Beschichtung,
dadurch gekennzeichnet, daß sie ein Mehrschichtenmaterial nach einem der Anspruche 1 bis 12 enthält.

14. Herstellungsverfahren eines Mehrschichtenmaterials nach einem der Anspruche 1 bis 12, durch Gasphasenabscheidung unter Vakuum auf einem Substrat, dadurch gekennzeichnet, daß es die folgenden Schritte umfaßt:
- Einführen eines Substrats (2) in einen Sputter- oder Aufdampfrezipienten,
- Durchführen eines Sputterns oder eines Aufdampfens, jeweils ausgehend von einem Target oder einer Quelle aus reinem Wolfram oder aus Wolframlegierung in einem Plasma, das alternativ aus einem Edelgas und aus 0% eines Zusatzgases oder aus einer Mischung von einerseits einem Edelgas und andrerseits 5 bis 25 Volumenprozent eines kohlenstoffhaltigen Zusatzgases gebildet wird oder aus 9 bis 30 Volumenprozent eines stickstoffhaltigen Zusatzgases, um abwechselnd auf dem Substrat (2) wenigstens eine duktile metallische Schicht (4) aus Wolfram oder Wolframlegierung und wenigstens eine harte Schicht (6) aus einer festen Lösung von Zusatzelementen in Wolfram oder in einer seiner Legierungen.

15. Herstellungsverfahren nach Anspruch 14,
dadurch gekennzeichnet, daß das kohlenstoffhaltige Gas ein Kohlenwasserstoff ist.

16. Herstellungsverfahren nach Anspruch 15,
dadurch gekennzeichnet, daß der Kohlenwasserstoff Methan ist.

## Claims

1. Multilayer material, characterized in that it comprises a substrate (2) covered with at least one ductile layer (4) of metallic tungsten or of a tungsten alloy and with at least one hard layer (6, 6a, 6b, 6c) of a solid solution of an addition element, chosen from carbon and nitrogen, in tungsten or in a tungsten alloy, the two types of layers (4) and (6, 6a, 6b, 6c) alternating and in that the carbon content in the solid solution (6, 6a, 6b, 6c) is less than 25 at.% or the nitrogen content in the solid solution (6, 6a, 6b, 6c) is between 0.5 and 15 at.%.

2. Multilayer material according to Claim 1, characterized in that the hard layer (6, 6a, 6b, 6c) is a mixed solid solution of carbon and nitrogen in tungsten or in a tungsten alloy.

3. Multilayer material according to Claim 1, characterized in that the carbon content in the solid solution (6, 6a, 6b, 6c) is between 12 and 18 at.%.

4. Multilayer material according to Claim 1, characterized in that the carbon content in the solid solution (6, 6a, 6b, 6c) is between 14 at.% and 15 at.%.

5. Multilayer material according to Claim 1, characterized in that the nitrogen content in the solid solution (6, 6a, 6b, 6c) is between 1 and 10 at.%.

6. Multilayer material according to any one of the preceding claims, characterized in that it comprises at least two successive hard layers (6, 6a, 6b) of solid solution having addition-element contents which are constant within each hard layer (6), successive hard layers having different addition-element contents.

7. Multilayer material according to Claim 6, characterized in that the successive hard layers (6, 6a, 6b) of solid solution have addition-element contents which are constant within each hard layer and increase in an entire set of successive hard layers.

8. Multilayer material according to Claim 7, characterized in that the hard layer (6) closest to the substrate (2) has the lowest addition-element content of the entire set of the successive hard layers (6, 6a, 6b).

9. Multilayer material according to any one of the preceding claims, characterized in that at least one (6c) of the hard layers has internally an increasing addition-element gradient in the solid solution, that part of the said hard layer comprising the lowest addition-element content being oriented towards the substrate (2).

10. Multilayer material according to Claim 1, characterized in that the tungsten alloy used in the ductile layer (4) and/or in the hard layer (6, 6a, 6b, 6c) is an alloy consisting of tungsten and of one or more other elements chosen from titanium, zirconium, hafnium, vanadium, niobium, tantalum, chromium, molybdenum, nickel, copper, aluminium, cobalt, iron, platinum and palladium.

11. Multilayer material according to Claim 1, characterized in that the substrate (2) is chosen from a titanium alloy, stainless steel, an aluminium alloy, a nickel alloy, polymers or composites.

12. Multilayer material according to Claim 1, characterized in that the thickness of each ductile layer (4) and hard layer (6, 6a, 6b, 6c) is between 0.01 µm and 50 µm, preferably between 0.05 and 25 µm, or better still between 0.2 and 15 µm.

13. Anti-erosion and anti-abrasion coating, characterized in that it comprises a multilayer material according to any one of Claims 1 to 12.

14. Process for manufacturing the multilayer material according to any one of Claims 1 to 12, by vacuum vapour deposition on a substrate, characterized in that it comprises the steps consisting in:
- introducing a substrate (2) into a sputtering or evaporation chamber;
- carrying out a sputtering operation or an evaporation operation using, respectively, a target or a source of pure tungsten or of tungsten alloy, in a plasma consisting alternately of a rare gas and of 0% of an addition gas or of a mixture of, on the one hand, a rare gas and, on the other hand, 5 to 25% by volume of an addition gas containing carbon or from 9 to 30% by volume of an addition gas containing nitrogen, so as to deposit alternately, on the substrate (2), at least one ductile layer (4) of metallic tungsten or of tungsten alloy and at least one hard layer (6) of a solid solution of an addition element in tungsten or in one of its alloys.

15. Manufacturing process according to Claim 14, characterized in that the gas containing carbon is a hydrocarbon.

16. Manufacturing process according to Claim 15, characterized in that the hydrocarbon is methane.
